# EUROPEAN PATENT APPLICATION

(11) **EP 4 530 615 A1**
(43) Date of publication of application: **02.04.2025**
(21) Application number: 24201620.2
(22) Date of filing: 20.09.2024
(51) Int. Cl.: G01N 23/2202, G01N 23/225, G01N 23/2251, H01J 37/304, H01J 37/31

(54) **ADAPTIVE SLICE DEPTH IN SLICE & VIEW WORKFLOW**

(30) Priority: 28.09.2023 US 202318476964
(71) Applicant: FEI Company, Hillsboro, OR 97124 (US)
(72) Inventor: VITECEK, Jiri, Hillsboro 97124-5793 (US); PRIBYL, Bronislav, Hillsboro 97124-5793 (US); PACURA, David, Hillsboro 97124-5793 (US)
(74) Representative: Boult Wade Tennant LLP

(57) **Abstract**

Milling depth is selected based on sample dimensions to increase the rate at which sample images are acquired. A cutface height and associated focused ion beam dose are selected based on an image of a previously acquired sectional surface. Edges in the image can be identified such as those corresponding to a sample mount or a coating applied to the sample and used to establish a CPB dose. Cutface height can be based on a single or multiple prior sectional surface images.

## Description

### FIELD

The disclosure pertains to adaptive focused ion beam sample slicing.

### BACKGROUND

In many applications in materials science and the life sciences, a series of two-dimensional images of a sample of interest is obtained and these images are combined to produce a three-dimensional image. The series of images can be obtained with an SEM by milling a sample and then imaging the milled surface. The milling/imaging sequence can be repeated as may be desirable to produce enough two-dimensional images to produce a satisfactory three-dimensional image. While this approach permits the construction of three-dimensional images, obtaining multiple images in this way can require lengthy processing times and extensive technician input. In typical examples, 500-1000 two-dimensional image are required and milling times for each can be considerable. Alternative approaches that could reduce one or both of total time and technician time are needed.

### SUMMARY

Milling depth is selected based on sample dimensions to increase the rate at which sample images are acquired. A cutface height and associated focused ion beam dose are selected based on an image of a previously exposed sectional surface. Edges in the image can be identified such as those corresponding to a sample mount or a coating applied to the sample and used to establish a charged-particle beam (CPB) dose for a subsequent milling operation. Dose can be based on a single or multiple prior sectional surface images.

The foregoing and other features and advantages of the technology will become more apparent from the following detailed description, which proceeds with reference to the accompanying figures.

### BRIEF DESCRIPTION OF THE DRAWINGS

FIG. 1 illustrates obtaining sectional surfaces of a sample.
FIG. 2 illustrates a representative method of acquiring images of sectional surfaces to produce a three-dimensional (3D) image of a sample.
FIG. 3 illustrates a representative dual beam system configured to produce and image sectional surfaces of a sample using adaptively determined charged particle beam (CPB) doses based on edge detection in one or more previously acquired sectional images.
FIG. 4 illustrates a sample situated for repetitive ion beam milling using an adaptively determined CPB dose.
FIGS. 5A-5C are images of representative sectional surfaces of a non-flat sample.
FIG. 6 is a representative sample image illustrating selection of a variable cutface width as well as a variable cutface height.
FIG. 7 is an image illustrating exposing sectional surfaces of a sample with a focused ion beam (FIB).
FIG. 8 illustrates sectional surfaces to be exposed for imaging.
FIG. 8A is a cross-sectional view of FIG. 8 illustrating a representative sectional surface.

### DETAILED DESCRIPTION

Methods and apparatus are disclosed that provide adaptive milling in order to produce a plurality of sectional surfaces which can be imaged to produce a 3D image of a sample. Based on a previously imaged sectional surface, a milling depth is adaptively selected for use in milling to expose a subsequent sectional surface.

### General Terminology

Dose generally refers to a total exposure to an ion beam or other charged particle beam (CPB) used to produce a surface to be imaged. Dose typically refers to a product of CPB current and exposure time at a fixed ion beam energy and fixed beam spot size. Effectiveness of a particular dose in milling is a function of the composition of the sample to be milled, the product of ion beam current and exposure time (dose), CPB energy, CPB spot size on the sample, CPB composition such as types of ions or other charged particles and can be selected as convenient. As used herein, a milling dose refers to a dose associated with a selected milling depth in a sample. The selected milling depth is referred to herein as an effective milling depth, i.e., an approximate milling depth associated with exposure of a particular sample to a particular CPB beam configuration. In the examples, dose is adaptively selected based on specimen dimensions and variations of dose based on sample composition are not used, but dose can be similarly adapted. A milling dose can be applied in multiple passes over of a sample area or the milling dose can be applied in a single exposure. While the examples are described with reference to CPB dose as this is a parameter controllable by a CPB system, in other examples, CPB systems can be configured based on a milling depth which corresponds to an effective dose.

The examples are generally described with systems in which milling is accomplished with an ion beam and imaging is based on exposure of a specimen to an electron beam (such as in SEM). However, milling can be accomplished with optical beams such as laser beams or CPBs other than ion beams such as electron beams. Similarly, images can be obtained in other ways as well based on optical radiation or other CPBs such as ion beams. Systems combining SEM imaging and ion beam milling are only convenient examples.

In various examples, the charged particles in the ion beam can originate from liquid metal ion sources that produce ions such as gallium; plasma ion sources that produce ions such as argon, nitrogen, oxygen, or xenon difluoride; or a combination of more than one liquid metal ion and/or plasma ion source.

As used herein, a sectional surface (or a slice surface) refers to a surface of a specimen for which an image is to be obtained. Generally a series of such surfaces is obtained and imaged in order to produce a 3D image. In the examples, a sample is milled to reveal a series of sectional surfaces; the associated images can be processed to produce a three-dimensional image of the specimen. Sectional surfaces can be spaced arbitrarily with adjacent sectional surfaces separated by 2 nm, 10 nm, 20 nm, 50 nm, 100 nm, 0.5 µm, 1.0 µm, 2 µm, 5 µm, 10 µm, 20 µm, 50 µm, or more. Spacing need not be uniform although it can be convenient to use a common sectional surface spacing. A sectional surface referred to as an initial sectional surface is any sectional surface that is used to determine dose or other exposure parameters for use in exposing one or more additional sectional surfaces. First and second sectional surfaces obtained without exposing any intervening sectional surfaces are referred to as adjacent. A previously exposed surface as used herein can be an adjacent or non-adjacent surface. Doses can be determined based on previously exposed adjacent or non-adjacent sectional surfaces. A sample height exposed by or to be exposed by milling is referred to herein as a "cutface height."

The term image is used to refer to a visual depiction of a specimen as well as a representation of a visual depiction as data storable in, for example, a JPG, TIFF, BMP, MPEG, or other data formats.

As used herein, a boundary is an outside limit of an object such as a sample, a coated sample, a sample situated on a sample mount, or a mounted, coated sample. A boundary can be specified by one or more edge locations ("edges"), by one or more curved and/or straight lines at edges or by one or more curved and/or straight lines that completely surround the object. A boundary is generally located in an image by edge detection or other image processing using a general purpose or dedicated processor.

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or instruments are referred to as "lowest" or "best" or other similar terms. It will be appreciated that such descriptions are intended to indicate that a selection among many used functional alternatives can be made, and such selections need not be better, smaller, or otherwise preferable to other selections.

Examples are described with reference to directions indicated as "above," "below," "upper," "lower," and the like. These terms are used for convenient description, but do not imply any particular spatial orientation.

### Example 1

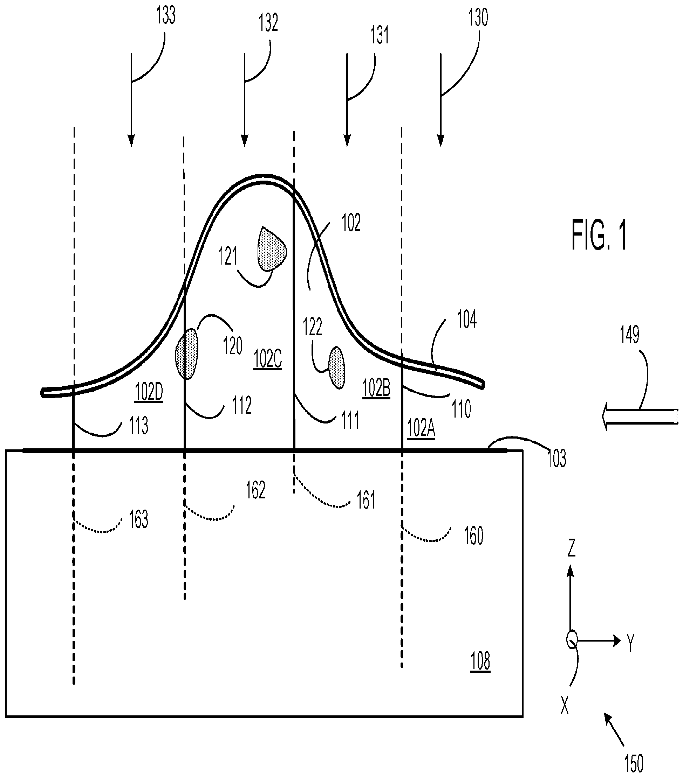

FIG. 1 illustrates processing of a sample to expose sectional surfaces for imaging and obtaining images of the exposed surfaces for producing a 3D sample reconstruction. With reference to FIG. 1, a sample of interest 102 (hereinafter "sample") is situated on a support member 103, such as a conductive grid which can be situated on a stub 108 or other specimen holder which can be used to position the sample 102 for charged-particle beam (CPB) processing and imaging. The sample 102 can be secured with conductive paint, conductive tape, clamps, or combinations thereof. The sample 102 is typically provided with a conductive coating 104 to reduce or eliminate charging artifacts in CPB imaging and processing such as SEM imaging and focused ion beam (FIB) milling. The sample 102 is shown as including one or more representative features of interest 120-122 to be included in images.

The sample 102 is situated on the stub 108 for imaging with a CPB 149 that is incident along one more axes that are generally approximately parallel to a Y-axis of a XYZ-coordinate system 150 in which an X-axis extends out of the plane of the drawing. A FIB or other processing beam is applied sequentially along axes 130-133 that are parallel to a Z-axis to remove respective sample sections 102A-102D by FIB milling and expose sectional surfaces 110-113 for imaging using the CPB 149. The particular angles shown in FIG. 1 are selected for purposes of illustration and both the FIB and the imaging CPB can be incident at different angles. The axes 130-133 are shown as different but FIB milling of different sample sections can be accomplished with a fixed FIB and translation of a sample with respect to the fixed FIB. In some cases, both sample position and FIB axis can be varied.

In the disclosed approaches, FIB dose applied along each of the axes 130-133 can be selected to avoid or limit FIB milling into the stub 108 and the sample mount 103 as images thereof are not necessary. Thus, a dose associated with removal by milling of a section 102A of the sample 102 is selected to expose a sectional surface 110 that extends from the coating 104 to the support member 103. In some cases, the dose is selected to mill into the support member 103 or deeper to be sure that the entire section surface 102A is exposed. This milling depth (i.e., the cutface height) and the associated dose can be determined by processing an image of the sectional surface 110. Such processing can be based on identification of a specimen boundary such as identification of one or more of the coating 104 and the sample support 108 in the image. Cutface height can be selected based on, for example, a distance between the coating 104 and the sample support 108 and dose based on the cutface height. For subsequent sectional surfaces, cutface height can be redetermined so that a cutface height to be used in determining doses for exposing sectional surfaces 111, 112, 113 and removing sample sections 102B, 102C, 102D are based on locations determined using images of sectional surfaces 110, 111, 112, respectively. In many practical examples, cutface height is slowly varying and redetermination of cutface height (and dose) can be done using images of only some sectional surfaces or using a series of previous images which can be sequential or non-sequential images.

In conventional approaches using a fixed dose, milling proceeds into the sample mount 103 and the stub 108 to depths indicated by lines 160-163. Milling this additional depth is time consuming, and the processing described herein avoids this unnecessary milling.

### Example 2

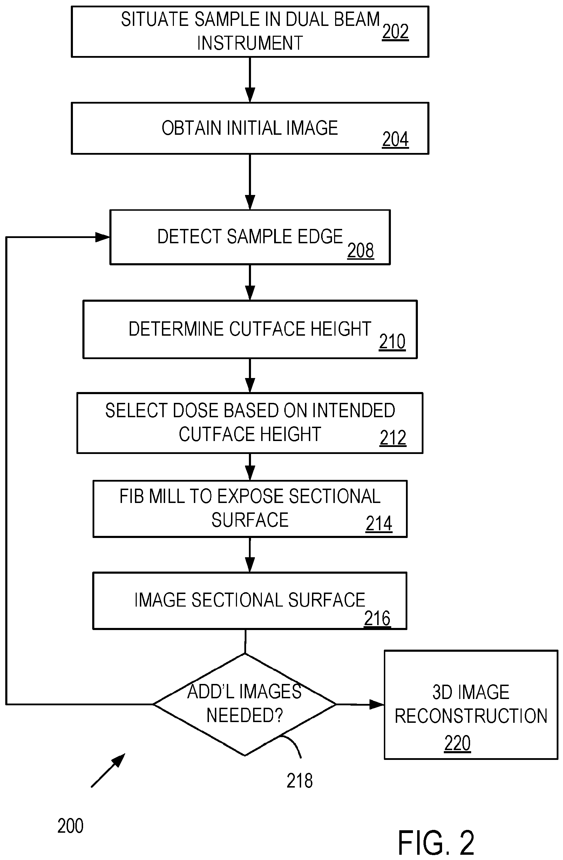

With reference to FIG. 2, a representative method 200 of obtaining sectional images using an adaptively selected CPB dose includes situating a sample in a dual CPB instrument at 202, typically in an instrument that includes CPB optics and sources for FIB milling and SEM imaging. The sample is generally situated so that the FIB can be incident at near normal incidence to a surface of a mounting stub which supports the sample. An electron beam used for SEM imaging is incident to the sample at angles between around 30-60 degrees, but other angles can be used. At 204, an SEM image of an initial sectional surface of the sample is obtained by, for example, retrieval of a previously acquired image or operating the SEM to acquire the image. In this example, SEM imaging is used, but other types of images are suitable such as images obtained with an ion beam. At 208, the image is processed to identify sample edges, a sample border, or other spatial limitations associated with the sample. At 210, an intended cutface height is determined based on the sample edges or other identified sample features, such as a cutface height of the initial sectional surface. This cutface height can be based on image portions associated with a sample coating, a sample mount, or other structures or components proximate the sample, or by evaluation of an image portion associated with the sample itself. At 212, an FIB dose is selected based on the intended cutface height, typically a dose large enough to accommodate sample thickness variations so that a subsequent sectional surface is fully exposed. At 214 the selected FIB dose is applied to expose the subsequent sectional surface and at 216 the newly exposed sectional surface is imaged. If additional images are needed for image reconstruction as determined at 218, processing returns to 208 and a sample edge in the newly obtained image is used, and the method continues to acquire an image of another sectional surface. If no additional images are to be acquired, a 3D image is constructed, stored, and/or communicated for viewing or otherwise made available at 220.

### Example 3. Imaging System

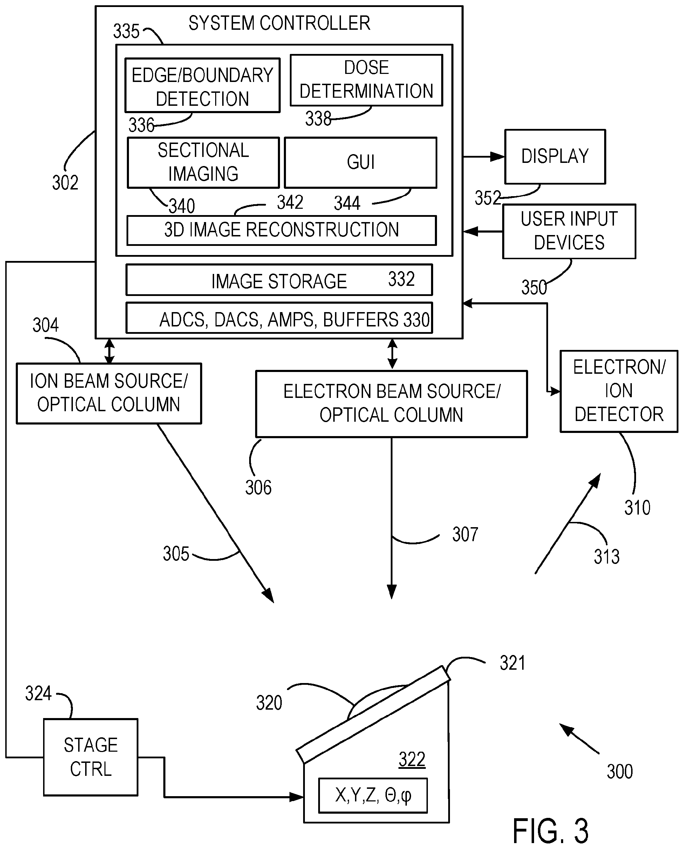

Referring to FIG. 3, a dual CPB system 300 includes a system controller 302 that is coupled to an ion beam source and optical column 304 and an electron beam source and optical column 306 that produce an ion beam 305 such as focused ion beam (FIB) and an electron beam 307, respectively. The ion beam 305 can be scanned or otherwise directed to a sample 320 to process the sample, by, for example, ion beam milling. The electron beam 307 is directed to the sample 320 to obtain SEM images. In some applications, images are obtained based on the ion beam 305 instead of the electron beam 307 in addition to processing the sample 320. One or more CPB detectors such as representative CPB detector 310 is situated to receive a CPB 313 based on, for example, scattered ions or electrons, secondary electrons responsive to the ion beam 305 and/or the electron beam 307 and used for CPB control and imaging. In other examples, characteristic X-rays and X-ray diffraction or transmitted electrons are detected and used. A camera can also be provided for specimen alignment and inspection but is not shown.

The sample 320 is secured to a sample mount 321 that is coupled to a stage 322 that is in communication with a stage controller 324 that is responsive to the system controller 302. The stage 322 generally can provide one or more translations, rotations, or tilts as directed by the system controller 302. The system controller 302 can include electronics 330 such as one or more analog-to-digital convertors (ADCs), digital to analog-convertors (DACs), amplifiers, and buffers for control of CPB detectors and processing (amplification, digitization, buffering) associated signals with one or more CPB detectors such as the CPB detector 313 as well as the optical columns associated with the ion beam and the electron beam. In most practical examples, at least one ADC is used to produce a digitized detector signal that can be stored in one or more tangible computer readable media (shown as image storage 332) as an image. In other examples, image storage is remote via a communication connection such as a wired or wireless network connection.

The system controller 302 is coupled to a memory 335 that stores processor-executable instructions for sectional image acquisition 340 and processing such as edge and boundary identification 336, dose determination 338, 3D image reconstruction 342, and to provide a GUI 344 for various functions, including numbers of sectional images to be acquired and an extent to which dose should be selected to compensate for variations in milling rate and sample thickness variations. Sectional images and reconstructed 3D images can be stored in the memory portion 332. Stage coordinates (including rotations) can be stored in memory portion 332 as well. The system controller 302 establishes image acquisition parameters and is in communication with the stage controller 324. Sample images (such as sectional images and 3D reconstructions) can be presented on a display 352, and system control and imaging parameters can be specified using internally stored values from the memory 335 or provided by a user with one or more user input devices 350. It will be appreciated that the layout of FIG. 3 is for convenient illustration, and actual alignments of various beam sources and detector(s) can be different.

The system controller 302 can be implemented with one or more of a general-purpose computing device in the form of an exemplary conventional PC or a special purpose computing device such as complex programmable logic devices (CPLDs) and field-programmable gate arrays. Methods can be implemented with such computing devices using computing device-executable instructions that are stored in one or more non-transitory computer-readable media. Such computer-executable instructions can be configured to implement any available edge detection method such as discussed below.

### Example 4

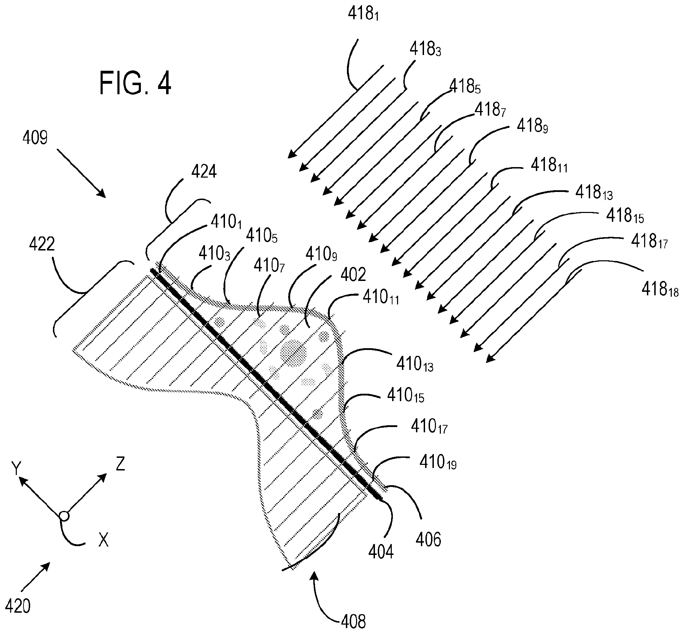

Referring to FIG. 4, a sample 402 to be investigated is situated on a sample mount 404, such as a metallic grid, a conductively coated member or other suitable support. The sample 404 is shown with a coating 406, typically a conductive coating to reduce charging effects. The sample 402 is situated between the sample mount 404 and the coating 406. In this example, the sample mount 404 is fixed to a mounting stub 408 which can be coupled to one or more actuators so that the specimen can be suitably positioned for SEM imaging with an imaging electron beam incident generally from an imaging direction 409. A set of sectional images is obtained by exposing representative surfaces 410₁, ... , 410₁₉ by FIB milling with a FIB received along respective axes 418₁, ... , 418₁₈. In FIG. 4, only selected sectional surfaces and FIB axes are labeled; other sectional surfaces and FIB axes are not labeled for ease of illustration.

Viewed from the imaging direction 409, a height of the specimen 402 measured along a Z-axis direction of a coordinate system 420 is variable. In order to prepare each of the sectional surfaces 410₁, ..., 410₁₉ for imaging, milling along the respective axes 418₁, ..., 418₁₈ need only expose surface portions between the sample mount 404 and the coating 406 in a region 424. While material removal can extend into a region 422 associated with the mounting stub 408 and the sample support 404, surface portions in this region are not needed for specimen images and processing time spent in removing material in the region 422 slows image acquisition.

The extensions of the sectional surfaces 410₁, ... , 410₁₉ beyond the specimen support 404 are illustrated as based on use of a common milling time for each of the axes 418₁, ... , 418₁₈. By milling to expose only the sectional surfaces 410ₙ of the sample 402, milling can be accomplished more quickly and the time required for image acquisition reduced. Milling of the sectional surfaces exposes sample surfaces and, in some cases, may expose portions of the coating 406, the sample mount 404, and the sample stub 408 selected to ensure complete exposure of a sectional surface as a result of milling. For example, the sectional surface 410₃ is obtained by milling along the axis 418₃ but no milling time need be used to mill into the region 422. For each of the milling axes 418, a different milling dose can be selected, depending on sectional surface height to be exposed, i.e., cutface height. By identifying sample edges such as locations of the sample 402 with respect to the sample support 404 and the coating 406, cutface height can be determined for a subsequent image and a suitable dose applied. As noted above, time savings can be significant. For example, in acquisition of 5,000 sectional images, time saved by avoiding milling in the region 422 can be as much as about 7 hours.

### Example 5

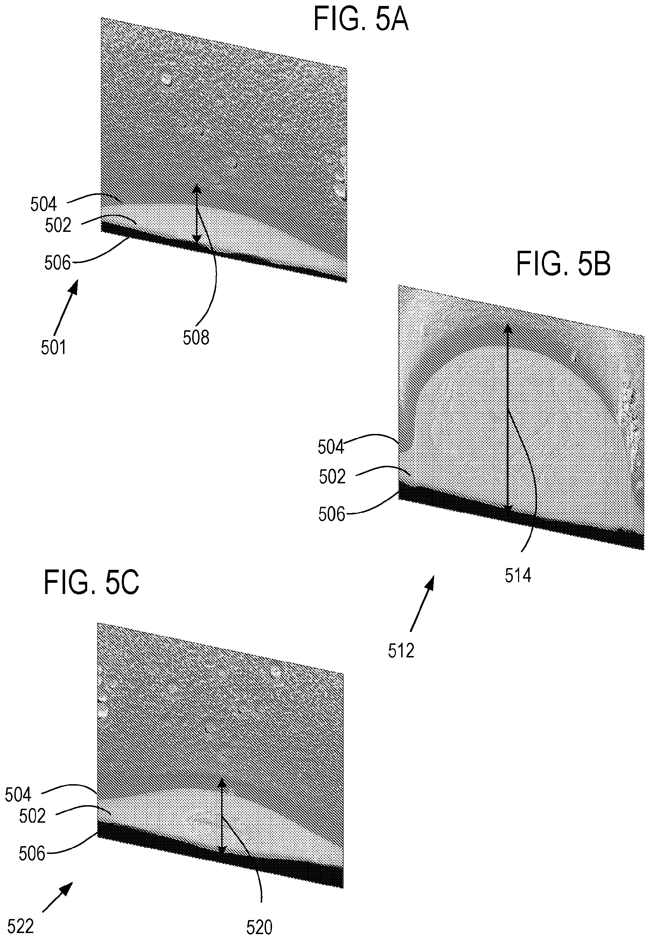

FIGS. 5A-5C illustrate sectional surfaces obtained by milling a sample secured to a sample support without extensive, time-wasting milling beyond the sample. In FIGS. 5A-5C, an FIB was directed generally from above the sample as situated in the drawings. Cutface heights 508, 514, 520 are shown for sectional surfaces 501, 512, 522, showing a sample 502 (a cell interior) with a coating 504 and situated on a sample support 506. Portions of the images above the coating 504 correspond the coated sample surface seen from an angle. For the sectional surfaces 501, 512, 522, doses are selected based on cutface heights of previously imaged sectional surfaces, and FIGS. 5A and 5C are associated with a lower dose than used to obtain the imaged sectional surface 511 shown in FIG. 5B. In most cases, sectional surfaces are closely spaced and cutface height changes slowly so that use of a previous sectional surface image is satisfactory. Only some sectional surface images can be used for estimating cutface height and dose, such as every other sectional surface image, every fifth, tenth, hundredth or other regularly or irregularly spaced sectional surface images, depending on thickness variations in the sample.

### Example 6

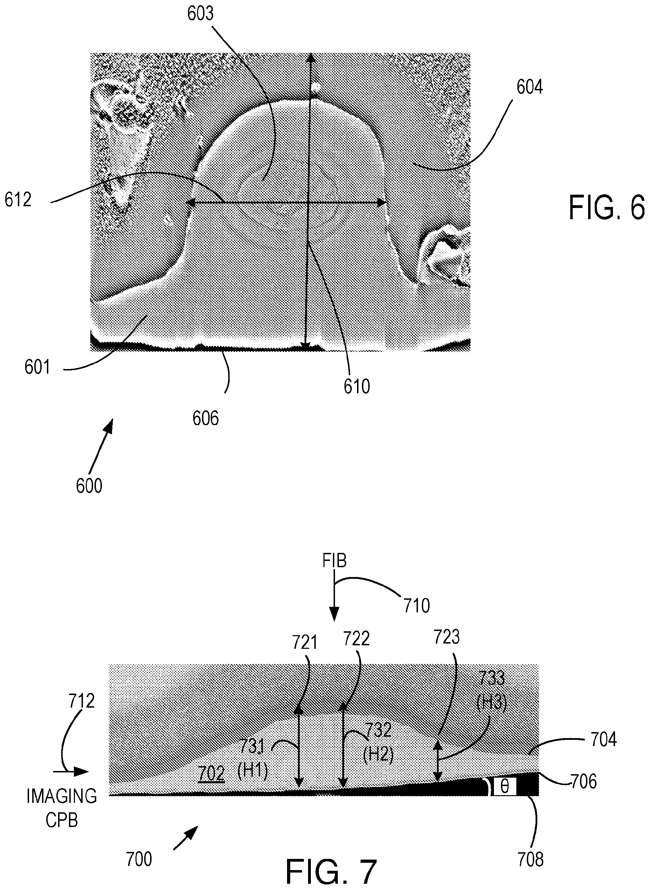

Additional time savings for image acquisition can be realized by suitable selection of a sample width to be milled, referred to herein as "cutface width." FIG. 6 is a representative sectional image 600 of a sample 601 (a cell) having a coating 604 and situated on a conductive foil 606. Using a previous sectional image, a suitable dose is selected to produce a cutface height 610 that extends to a top surface and bottom surface of the sample 601. A structure of interest 603 in the sample 601 is confined laterally; other portions of the sample 602 are not needed for 3D image reconstruction. Using edge detection, a cutface width such as cutface width 612 can be selected and milling performed only within this width. This can further decrease image acquisition time.

### Example 7

With reference to FIG. 7, a representative sample 702 (a cell) is situated between a sample mount 706, in this example, a conductive foil, and a coating 704 such as a conductive coating or a protective or other coating. The sample mount is in contact with a stub 708 which is used for positioning in a dual CPB instrument. An FIB is to be applied along an axis 710 and an imaging CPB along an axis 712. Three sectional surfaces 731-733 associated with respective cutface heights H1-H3 are shown. In most examples, hundreds of sectional surfaces are to be milled and imaged, and only three are shown in FIG. 7 for convenient illustration. Sample thickness variations between sectional surfaces tend to be small. An FIB dose for the sectional surface 732 can be obtained by processing an image of the sectional surface 731 to identify at least one edge, such as edge 721. The cutface height H1 can be calculated based on the identified edge, and a suitable dose for milling this height used in milling the sectional surface 732. The applied dose can include contributions associated with milling the coating 704 as well as an additional amount to account for possible increases in sample thickness at the sectional surface 732.

After milling to expose the sectional surface 732, an image is obtained. Then, an FIB dose for the sectional surface 733 can be obtained by processing the image of the sectional surface 732 to identify at least one edge, such as edge 722. The cutface height H2 can be calculated based on the identified edge, and a suitable dose for milling this height used in milling the sectional surface 733. The applied dose can include contributions associated with milling the coating 704 as well as an additional amount to account for possible increases in sample thickness at the sectional surface 733. After this milling, the cutface height H3 is measured by identifying an edge 723 in the image of the sectional surface 733 and used to determine dose for milling to expose a subsequent sectional surface.

In some examples, edges associated with the sample mount 706 or the stub 708 are used. In this example, these edges are associated with a tilt θ of the stub 708, and a dose determined for exposing the sectional surface using both top and bottom edges is reduced in comparison to dose associated with a top edge only. For oppositely directed tilts, determined doses would increase as sample thickness is larger than indicated based on upper edges only. In most cases, an image of a single previously acquired sectional surface is sufficient but using two or more previous images permit doses to be determined on rates of change of sample thickness or sample tilts.

### Example 8

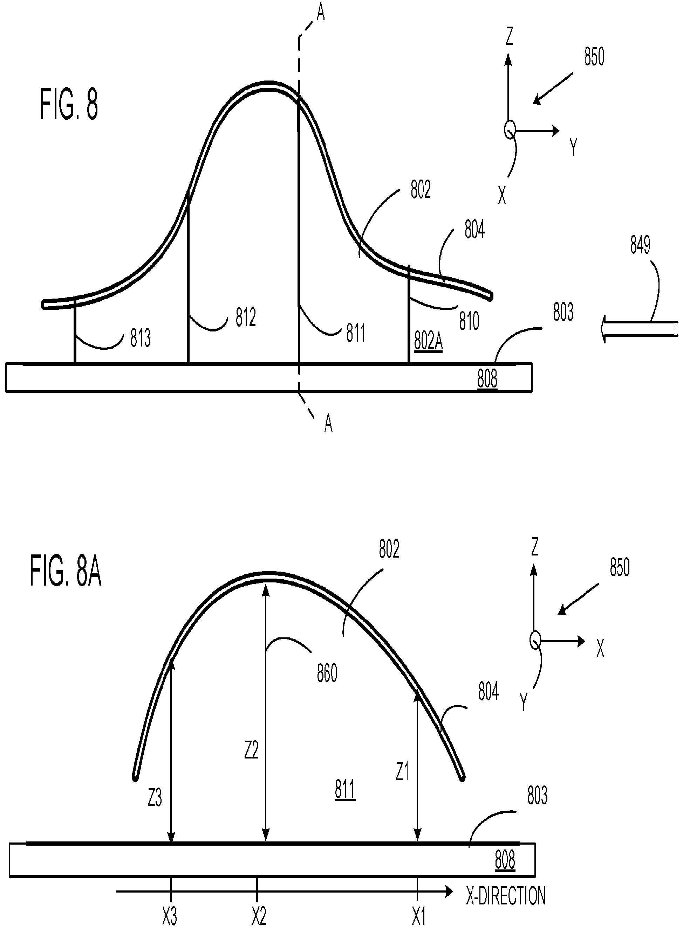

FIG. 8 illustrates processing of a sample 802 to expose sectional surfaces 810-813 for imaging and obtaining images of the exposed surfaces for producing a 3D sample reconstruction. The sample 802 is situated on a support member 803, such as a conductive grid which can be situated on a stub 808 which can be used to position the sample 802 for charged-particle beam (CPB) processing and imaging. The sample 802 is typically provided with a conductive coating 804 to reduce or eliminate charging artifacts in CPB imaging and processing. Processing to expose the sectional surfaces 810-813 can be accomplished as described above with reference to FIG. 1. As shown, an imaging CPB 849 is incident along one more axes that are generally approximately parallel to a Y-axis of a XYZ-coordinate system 850 in which an X-axis extends out of the plane of the drawing. The sectional surfaces 810-813 extend along respective XZ-planes in the coordinate system 850 and cutface heights measured as Z coordinates are determined as function of an X-coordinate as is apparent from the different cutface heights associated with the sectional surfaces 810-813, i.e., a height Z*ₘᵢₗₗ* of material to be removed to expose a cutface is given by s Z*ₘᵢₗₗ* = *Zₘᵢₗₗ*(*Y*).

FIG. 8A is a cross-sectional view illustrating the sectional surface 811. Height of the sectional surface 811 varies along the X-axis. F or example, at X-coordinates X1-X3, milling is performed based on heights Z1-Z3 which can all be different so that different doses are required. Thus, milling time can be further reduced based on specimen thickness variation in an XZ-plane (in addition to thickness variations in a YZ-plane) that can be determined based on identification of one or more edges in one or more sectional surface images. A series of sectional images such as nearby or adjacent sectional images can be used to determined heights to be milled. In the same manner as discussed above, rates of change of sample height can be used to determine which and how many sectional surfaces images are to be used to establish doses required to expose a subsequent sectional surface. In this approach, the height Z*ₘᵢₗₗ* of material to be removed to expose a cutface is given by Z*ₘᵢₗₗ* = *Zₘᵢₗₗ*(*X*,*Y*). While varying dose as a function of Y-coordinate provides substantial time, use of X-coordinate variations can further reduce total processing time. The height Z*ₘᵢₗₗ* is used to determine ion beam dose, or other exposure parameters associated with material removal such as CPB or optical beam average power, peak power, duty cycle, repetition rate, current, current per unit area, beam energies or wavelengths or other parameters.

### Example 9

Various methods can be applied to identify sample edges or boundaries with or without coatings or sample supports. For example, Sobel filtering can be used in which a pair of convolution kernels are used to compute gradient magnitudes of image intensity and identify edges, typically at locations with relatively large gradient magnitudes. A so-called canny edge detection method can be used in which an image is smoothed prior to determining gradient magnitudes, followed by steps in which non-maximum edges are suppressed, following by hysteresis thresholding. A Laplacian of Gaussian (LoG) filter can be used in which an image is convolved with a Laplacian of Gaussian filter. In another example, a Prewitt operator method which uses convolution kernels to compute a gradient magnitude of the image intensity at each pixel, similar to the Sobel filter. Other methods include use of a Roberts cross operator based or a zero-crossing detector which is based on finding zero crossings in a second derivative of image intensity. Artificial intelligence (AI) approaches can also be used such as convolutional neural networks or other deep learning methods, or other computer vision or machine learning methods.

### Additional Disclosure Clauses

Clause 1 is method comprising, with a processor, identifying a boundary of a sample in an initial sectional surface of the sample; milling the sample based on the identified boundary to reveal a subsequent sectional surface; and obtaining a charged particle beam (CPB) image of at least a portion of the subsequent sectional surface.

Clause 2 includes the subject matter of Clause 1, and further specifies that the identified boundary of the sample in the initial sectional surface of the sample is obtained based on an image of the initial sectional surface.

Clause 3 includes the subject matter of any of Clauses 1-2, and further specifies that the identifying the boundary includes identifying at least one edge in the image of the initial sectional surface of the sample, wherein the sample is milled to a selected depth based on the identified at least one edge.

Clause 4 includes the subject matter of any of Clauses 1-3, and further specifies that the identifying the boundary includes identifying a sample perimeter in the image of the initial sectional surface of the sample and the sample is milled to a selected depth based on the sample perimeter.

Clause 5 includes the subject matter of any of Clauses 1-4, and further includes repetitively: with the processor, identifying an edge of a previously imaged sectional surface; milling the sample based on the identified edge of the previously imaged sectional surface to reveal a subsequent sectional surface; and obtaining a CPB image of the subsequent sectional surface.

Clause 6 includes the subject matter of any of Clauses 1-5, and further specifies that for a plurality of subsequent millings of the sample based on the identified edge of the previously imaged sectional surface, the sample is milled with a fixed dose.

Clause 7 includes the subject matter of any of Clauses 1-6, and further specifies that the fixed dose is selected based on a cutface height associated with the previously imaged sectional surface.

Clause 8 includes the subject matter of any of Clauses 1-7, and further specifies that for at least two of a plurality of millings of the sample based on the identified edge of the previously imaged sectional surface, the sample is milled with different doses.

Clause 9 includes the subject matter of any of Clauses 1-8, and further specifies that the different doses are based on cutface heights associated with images of at least two previously obtained cutface surfaces.

Clause 10 includes the subject matter of any of Clauses 1-9, and further includes repetitively: with the processor, identifying an edge of a previously imaged sectional surface; milling the sample based on the identified edge of the previously imaged sectional surface to reveal a subsequent sectional surface, wherein the subsequent sectional surface is non-adjacent to the previously imaged sectional surface; and obtaining a CPB image of the subsequent sectional surface.

Clause 11 includes the subject matter of any of Clauses 1-10, and further specifies that the identifying the boundary includes identifying a first edge and a second edge in the image of the initial sectional surface of the sample, wherein the sample is milled to a selected depth between the first edge and the second edge.

Clause 12 includes the subject matter of any of Clauses 1-11, and further specifies that the sample is milled to the selected depth only between the first edge and the second edge.

Clause 13 includes the subject matter of any of Clauses 1-12, and further specifies that at least a portion of the sample boundary is associated with a sample support to which the sample is secured.

Clause 14 includes the subject matter of any of Clauses 1-13, and further specifies that at least a portion of the sample boundary is associated with a coating applied to the sample.

Clause 15 includes the subject matter of any of Clauses 1-14, and further specifies that the milling is ion beam milling and the CPB image is an SEM image.

Clause 16 includes the subject matter of any of Clauses 1-15, and further includes combining the CPB images of the sectional surfaces to produce a three-dimensional image.

Clause 17 is a dual beam apparatus, including: an ion beam optical system situated to direct an ion beam to a sample; a charged-particle beam (CPB) imaging system situated to produce sample images; and a system controller coupled to the ion beam optical system and the CPB imaging system and operable to control the ion beam to expose a subsequent sectional surface of the sample with the ion beam based on a previous image acquired with the CPB imaging system.

Clause 18 includes the subject matter of Clause 17, and further specifies that the system controller is operable to identify an edge in the previous image and the subsequent sectional surface is exposed based on the identified edge.

Clause 19 includes the subject matter of any of Clauses 17-18, and further specifies that the system controller is operable to sequentially expose sectional surfaces of the sample with the ion beam based on at least one prior sectional surface image obtained with the CPB imaging system.

Clause 20 includes the subject matter of any of Clauses 17-19, and further specifies that the system controller is operable to identify at least one edge in the previous image acquired with the CPB imaging system and select a dose to be applied to produce a subsequent sectional surface based on the identified at least one edge.

Clause 21 includes the subject matter of any of Clauses 17-20, and further specifies that the system controller is operable to expose a subsequent sectional surface of the sample with the ion beam based on a cutface height associated with the previous image.

Clause 22 includes the subject matter of any of Clauses 17-21, and further specifies that the system controller is operable to select a dose to be applied to expose the subsequent sectional surface of the sample with the ion beam based on a cutface height associated with the previous image, wherein the previous image is associated with a non-adjacent sectional surface.

In view of the many possible embodiments to which the principles of the disclosed technology may be applied, it should be recognized that the illustrated embodiments are only preferred examples and should not be taken as limiting the scope of the disclosure.

## Claims

1. A method, comprising:
with a processor, identifying a boundary of a sample in an initial sectional surface of the sample;
milling the sample based on the identified boundary to reveal a subsequent sectional surface; and
obtaining a charged particle beam (CPB) image of at least a portion of the subsequent sectional surface.

2. The method of claim 1, wherein the identified boundary of the sample in the initial sectional surface of the sample is obtained based on an image of the initial sectional surface.

3. The method of claim 1, wherein the identifying the boundary includes identifying at least one edge in the image of the initial sectional surface of the sample, wherein the sample is milled to a selected depth based on the identified at least one edge.

4. The method of claim 1, wherein the identifying the boundary includes identifying a sample perimeter in the image of the initial sectional surface of the sample and the sample is milled to a selected depth based on the sample perimeter.

5. The method of claim 1, further comprising repetitively:
with the processor, identifying an edge of a previously imaged sectional surface;
milling the sample based on the identified edge of the previously imaged sectional surface to reveal a subsequent sectional surface; and
obtaining a CPB image of the subsequent sectional surface.

6. The method of claim 5, wherein for a plurality of subsequent millings of the sample based on the identified edge of the previously imaged sectional surface, the sample is milled with a fixed dose.

7. The method of claim 6, wherein the fixed dose is selected based on a cutface height associated with the previously imaged sectional surface.

8. The method of claim 5, wherein for at least two of a plurality of millings of the sample based on the identified edge of the previously imaged sectional surface, the sample is milled with different doses.

9. The method of claim 8, wherein the different doses are based on cutface heights associated with images of at least two previously obtained cutface surfaces.

10. The method of claim 1, further comprising repetitively:
with the processor, identifying an edge of a previously imaged sectional surface;
milling the sample based on the identified edge of the previously imaged sectional surface to reveal a subsequent sectional surface, wherein the subsequent sectional surface is non-adjacent to the previously imaged sectional surface; and
obtaining a CPB image of the subsequent sectional surface.

11. The method of claim 10, wherein the identifying the boundary includes identifying a first edge and a second edge in the image of the initial sectional surface of the sample, wherein the sample is milled to a selected depth between the first edge and the second edge.

12. The method of claim 11, wherein the selected depth is a function of a transverse coordinate associated with the identified edge in the previously imaged sectional surface.

13. The method of claim 1, wherein at least a portion of the sample boundary is associated with a sample support to which the sample is secured, or associated with a coating applied to the sample.

14. The method of claim 2, wherein the milling is ion beam milling and the CPB image is an SEM image.

15. The method of claim 10, further comprising combining the CPB images of the sectional surfaces to produce a three-dimensional image.
